# EUROPEAN PATENT SPECIFICATION

(11) **EP 2 337 435 B1**
(45) Date of publication and mention of the grant of the patent: **24.10.2012**
(21) Application number: 09290955.5
(22) Date of filing: 17.12.2009
(51) Int. Cl.: H05K 7/18, H04Q 1/10

(54) **Flexible telecommunication cabinet**
Flexibler Telekommunikationsschrank
Boîtier de télécommunication flexible

(43) Date of publication of application: 22.06.2011
(73) Proprietor: Alcatel Lucent, 75007 Paris (FR)
(72) Inventor: Pintelon, Johan, 9420 De Haan (BE); Ouwersloot, Nico, 3882 BN Putten (NL); Content, Jurgen, 8370 Blankenberge (BE)
(74) Representative: Narmon, Gisèle Marie Thérèse

(56) References cited:
- EP-A1- 0 849 850
- US-A- 5 608 609
- US-A1- 2004 114 326
- US-A1- 2004 240 161

## Description

The present invention relates to a telecommunication cabinet assembly comprising a bottom enclosure housing passive equipment and a top enclosure housing active equipment.

Such a telecommunication cabinet assembly is generally known in the art. With the migration of the Access Network to higher bandwidth and as such to VDSL technologies, it is needed that the access equipment is deployed closer to the end customer. Typically this is done through deployment of active access equipment in a cabinet, or enclosure, near to a "passive" cabinet.

In many cases customers have existing "passive" cabinets, hereafter also called "bottom enclosures", housing non-active equipment on street corners to house the Main Distribution Frame MDF, grouping a number of customers from one or multiple streets or buildings.

Typically the existing passive street cabinets are not suited to house active equipment, nor can active equipment be bolted thereon. So, in case customers want to install active equipment, a new cabinet needs to be deployed using additional foot print and floor space.

An object of the present invention is to provide a low cost telecommunication cabinet assembly of the above known type and requiring no additional floor space when active equipment is added to the existing passive equipment.

According to the invention, this object is achieved due to the fact that said top enclosure has a bottom side provided with an external interface, that said bottom enclosure has a top side provided with an aperture, and that said top enclosure is adapted to be placed on top of said bottom enclosure whereby said external interface is engaged through said aperture.

In this way, there is no longer a need of deploying an active cabinet near to the existing passive cabinet thereby using additional foot print and floor space. The top enclosure, substituting the active cabinet, is placed on top of the passive cabinet or bottom enclosure, which may further be of any size. The internal equipments of the cabinets or enclosures are interconnected by means of the external interface.

In addition of re-using the available floor space, the 2-fold cabinet or telecommunication cabinet assembly of the present invention is flexible to accommodate different sizes of existing distribution frames and cabinets.

This telecommunication cabinet assembly allows a customer to plan network upgrades in a cost-efficient way and be future proof towards new technologies.

It is to be noted that the Patent Application US 5 608 609 (A) of MORRELL EDWARD A, published on March 4, 1997 and entitled "Outdoor cabinet for electronic equipment" discloses a cabinet for housing electronic equipment. This known cabinet includes a sealed first portion enclosing circuit packs such as those used for broadband and narrowband telecommunications transmission. The second portion is ventilated and encloses electrical components such as coaxial cable hardware.

This document may be considered as technological background information for the present invention.

It is also to be noted that the Patent Application US 2004/114326 (A1) of DODGEN CHARLES H et al, published on June 17, 2004 and entitled "OUTDOOR ELECTRONIC EQUIPMENT CABINET" discloses an outdoor telecommunication cabinet comprising an electronic compartment adapted to contain heat-generating electrical equipment, having a main electronic compartment including a rear wall panel and two clamshell doors, a floor panel and a cover panel, including access areas and an equipment storage area, the main compartment being adapted to contain heat-generating electrical equipment, at least one rack inside said main electronic compartment for electronic equipment, a base assembly supporting the said electronic compartment, having a width and depth similar to said main electronic compartment capable of being anchored to a base plate or pad, a ventilated sub-compartment in the base assembly containing an environmental cooling system, a pair of clamshell doors, movable between an open position permitting access to both front and back sides of said electrical equipment and a closed position in which the doors maintain a substantially closed environment in the electronic compartment, a cable entry port, typically on the rear wall panel, and a return air duct assembly mounted to said rear panel to form an enclosed duct vertically traversing the length of the electronic compartment and interfacing with a cutout area on the floor panel for circulating airflow through an enclosed path to the electronic compartment.

Again this document may be considered as technological background information for the present invention.

It is finally to be noted that the Patent Application US 2004/240161 (A1) of MILLER WILLIAM et al, published on December 2, 2004 and entitled "Remote enclosure systems and methods of production thereof" discloses remote enclosure systems that have been designed and are described therein that meet the following goals:
a) consolidates electrical terminations in one system;
b) pre-terminates AC and DC equipment loads before site installation;
c) provides multiple access points for facilitating equipment repair and installation;
d) is easily expanded through the use of additional systems or expansion cabinets; and
e) is aesthetically functional given the cable entry and routing structure.

Remote enclosure systems generally comprise:
a) a frame system further comprising at least two side panels;
b) at least one door coupled to the frame system;
c) at least one removable radiofrequency (RF) port plate coupled to at least one of the side panels and/or the frame system;
d) a bottom panel coupled to the frame system; and
e) a cable management top assembly coupled to the frame system.

The remote enclosure system may also comprise any number of components suitable for electronics, wireless and cable-based data and telecommunications applications, including air conditioner exhaust member, an air conditioner unit, a battery pack, a meter base, a power receptacle box, an alarm system or alarm device, an expansion cabinet, a coupling device or system, a pre-wiring system and/or a demarcation component.

A remote enclosure system may be produced by:
a) providing a frame system having at least two side panels, at least one door coupled to the frame system. at least one removable RF port plate coupled to at least one of the side panels, a bottom panel coupled to the frame system, and a cable management top assembly coupled to the frame system;
b) providing an expansion cabinet; and
c) coupling the frame system to the expansion cabinet through a coupling interface.

Also this document may be considered as technological background information for the present invention.Another characterizing embodiment of the present invention is that said bottom enclosure has one side provided with an access door with a first lock, and that said top enclosure has one side provided with an access door with a second lock.

In this way, two distinct doors with different locks are provided to prevent, e.g., access to the active equipment by a level 1 field technician who should only have access to the passive equipment, i.e. to the bottom enclosure.

In a preferred characterizing embodiment of the present invention, the aperture on the top side of said bottom enclosure is adapted to be closed by a removable waterproof top piece or to receive an external interface of a top enclosure placed on top of said bottom enclosure, said external interface being adapted to be connected to a distribution frame in said bottom enclosure.

In other words, the aperture is closed by the removable waterproof top piece or roof hat as long as the bottom enclosure or passive cabinet is used alone. The removable waterproof top piece is removed when a top enclosure is placed on top of the bottom enclosure.

Further characterizing embodiments of the present telecommunication cabinet assembly are mentioned in the appended claims.

It is to be noticed that the term 'comprising', used in the claims, should not be interpreted as being restricted to the means listed thereafter. Thus, the scope of the expression 'a device comprising means A and B' should not be limited to devices consisting only of components A and B. It means that with respect to the present invention, the only relevant components of the device are A and B.

Similarly, it is to be noticed that the term 'coupled', also used in the claims, should not be interpreted as being restricted to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

The above and other objects and features of the invention will become more apparent and the invention itself will be best understood by referring to the following description of an embodiment taken in conjunction with the accompanying drawings wherein:
**Fig. 1** shows a passive telecommunication cabinet as part of the telecommunication cabinet assembly according to the invention;
**Fig. 2** shows an active telecommunication cabinet or top enclosure of the telecommunication cabinet assembly;
**Fig. 3** shows the passive telecommunication cabinet of Fig. 1 as bottom enclosure of the telecommunication cabinet assembly; and
**Fig. 4** shows the telecommunication cabinet assembly with its top and bottom enclosures.

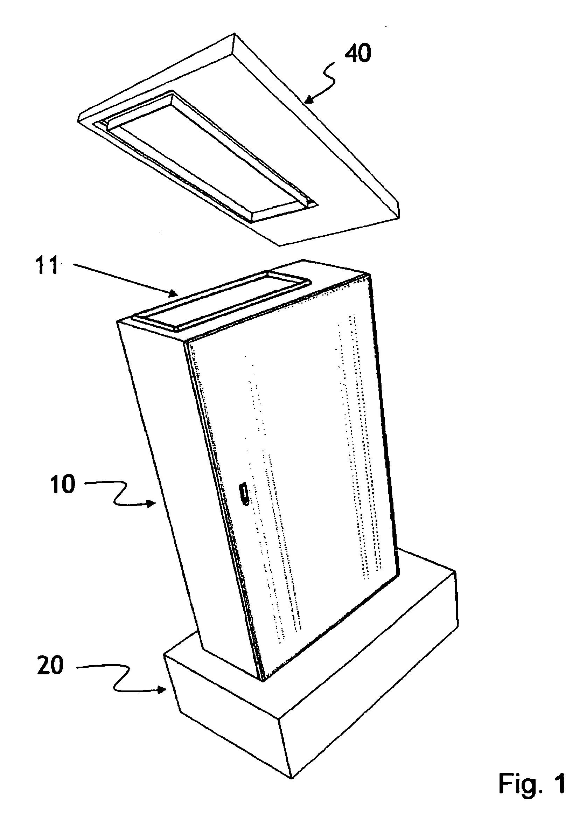

The cabinet 10 shown at Fig. 1 is an outside or street cabinet housing cross-connect or passive equipment such as Main Distribution Frame MDF frames and blocks. The cabinet 10 is mounted on a base surface 20 and has a top side provided with an aperture 11. The aperture 11 can be closed by a removable waterproof top piece or roof hat 40.

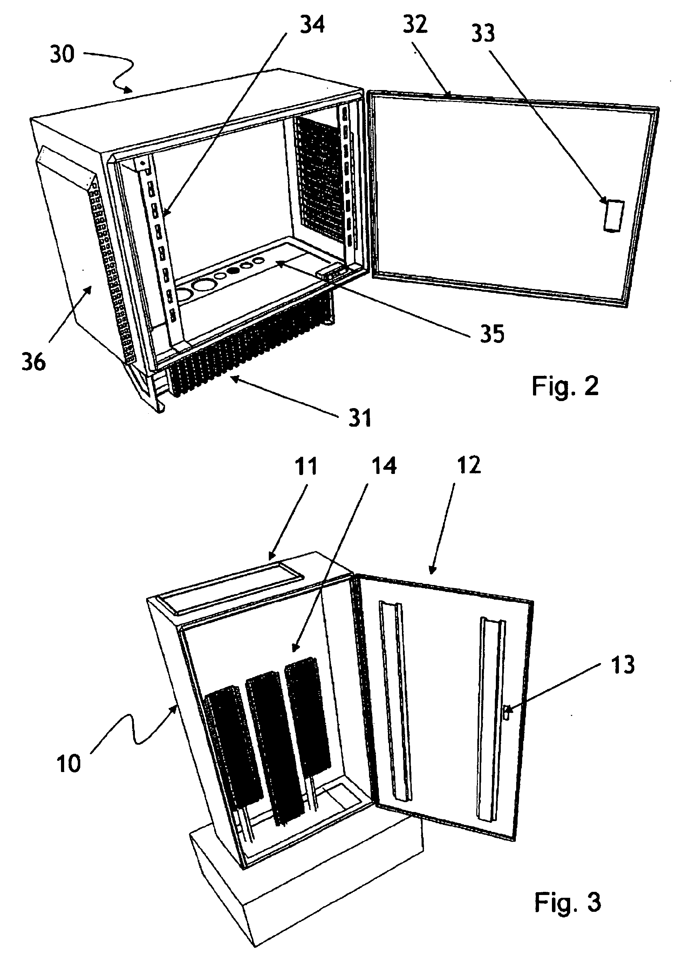

The passive cabinet 10 with its top aperture 11 is adapted to receive a second cabinet or enclosure 30, as shown at Fig. 2, mounted on top of it.

The top enclosure 30 is an active body that houses active equipment such as access equipment and additional MDF frames and blocks for customer routing. The access equipment is mounted on support features 34 and is coupled to an external interface 31 extending below the bottom of the top enclosure 30.

The top enclosure 30 is further preferably a sealed cabinet provided with an interface sealing 35 and independent thermal management means 36.

The top enclosure 30 has a front side provided an access door 32 having an independent lock 33.

Similarly, and as shown at Fig. 3, the passive cabinet, used as bottom enclosure 10, also has a front side provided with an access door 12 having an independent lock 13.

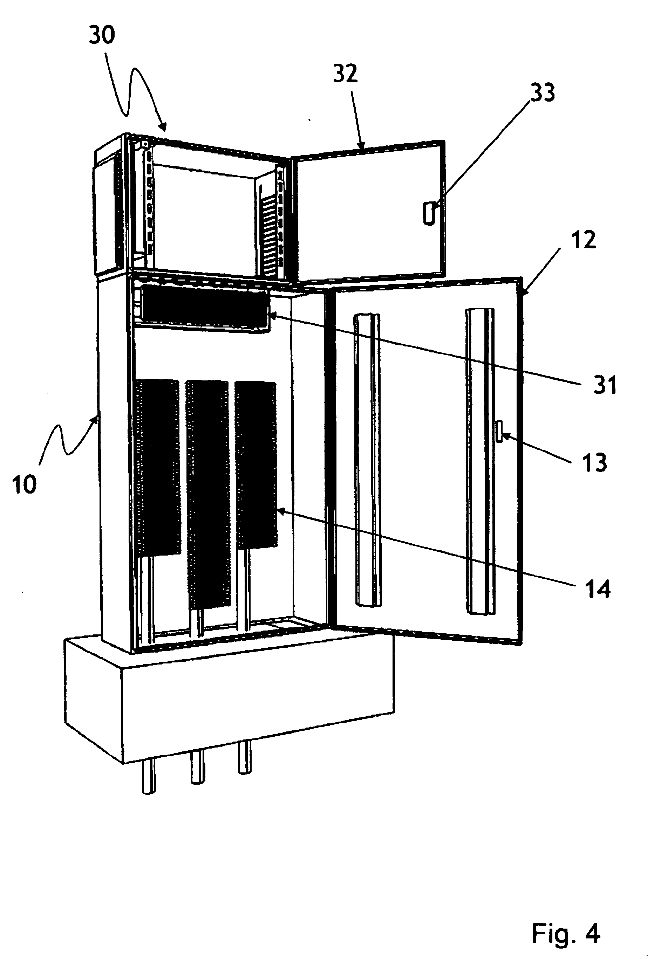

Upon assembly of the 2-fold telecommunication cabinet, shown at Fig. 4, the external interface 31 at the bottom of the top enclosure or active cabinet 30 slides in the bottom enclosure or passive cabinet 10 through the interface opening or aperture 11 thereof. A distribution frame 14 of the passive equipment of the bottom enclosure 10 may then be connected to the external interface 31 and so further be coupled to the active equipment of the top cabinet 30.

A telecommunication cabinet assembly with a separation between the active and passive equipment, and with an active cross-connect slide in the passive body is so obtained. The separation of the enclosures 10/30 and the distinct access doors 12/32 with their independent locks 13/33 ensures distinct handling of the active equipment by a level 2 or 3 field technician and of the passive equipment, e.g. the cross-connect, by a level 1 field technician.

Because of the split between passive and active body, a whole range of cabinet types and sizes can be made just by varying the low-cost passive body. The telecommunication cabinet assembly of the present invention is thus flexible to accommodate different sizes of existing distribution frames and cabinets, including tall and deep versions of the bottom or passive enclosure 10.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

## Claims

1. A telecommunication cabinet assembly comprising a bottom enclosure (10) housing passive equipment such as main distribution frames and blocks and a top enclosure (30) housing active equipment such as access equipment and additional distribution frames and blocks for customer routing,
***characterized in that*** said top enclosure (30) has a bottom side provided with an external interface (31),
***in that*** said bottom enclosure (10) has a top side provided with an aperture (11),
and ***in that*** said top enclosure is adapted to be placed on top of said bottom enclosure whereby said external interface is engaged through said aperture.

2. The telecommunication cabinet assembly according to claim **1,**
***characterized in that*** said external interface (31) the top enclosure (30) is adapted to slide through said aperture (11) of the bottom enclosure (10),
*and **in that*** said external interface is adapted to be connected to a distribution frame (14) in said bottom enclosure.

3. The telecommunication cabinet assembly according to claim **2,** ***characterized in that*** said top enclosure is sealed.

4. The telecommunication cabinet assembly according to claim **1,**
***characterized in that*** said bottom enclosure (10) has one side provided with an access door (12) with a first lock (13),
***and* in *that*** said top enclosure(30) has one side provided with an access door (32) with a second lock (33).

5. The telecommunication cabinet assembly according to claim **4,** ***characterized in that*** said one side is a front side.

6. The telecommunication cabinet assembly according to claim **1**, ***characterized in that*** said telecommunication cabinet assembly is a street cabinet adapted to be located outside.

7. A telecommunication bottom enclosure (10) for housing passive equipment such as main distribution frames and blocks,
***characterized in that*** said bottom enclosure (10) has a top side provided with an aperture (11) adapted to be closed by a removable waterproof top piece (40) and to receive an external interface (31) of a top enclosure (30) housing active equipment such as access equipment and additional distribution frames and blocks for customer routing placed on top of said bottom enclosure,
***and in that*** said external interface is adapted to be connected to a distribution frame (14) in said bottom enclosure.

8. The telecommunication bottom enclosure (10) according to claim 7, ***characterized in that*** said bottom enclosure (10) has one side provided with an access door (12) with a first lock (13).

9. The telecommunication bottom enclosure (10) according to claim **8**, ***characterized in that*** said one side is a front side.

10. The telecommunication bottom enclosure (10) according to claim **7**, ***characterized in that*** said bottom enclosure (10) is a street cabinet adapted to be located outside.

## Patentansprüche

1. Telekommunikationsschrank-Anordnung, umfassend ein unteres Gehäuse (10), in welchem passive Vorrichtungen wie beispielsweise Hauptverteilerrahmen und -blöcke untergebracht sind, und ein oberes Gehäuse (30), in welchem aktive Vorrichtungen wie beispielsweise Zugangsvorrichtungen und zusätzliche Verteilerrahmen und -blöcke für Kunden-Routing untergebracht sind,
***dadurch gekennzeichnet, dass*** das besagte obere Gehäuse (30) eine mit einer externen Schnittstelle (31) versehene Unterseite aufweist,
*dass* das besagte untere Gehäuse (10) eine mit einer Öffnung (11) versehene Oberseite aufweist,
*und dass* das besagte obere Gehäuse für das Anbringen auf dem besagten unteren Gehäuse vorgesehen ist, wobei die besagte externe Schnittstelle die besagte Öffnung durchgreift.

2. Telekommunikationsschrank-Anordnung nach Anspruch **1,**
***dadurch gekennzeichnet, dass*** die besagte externe Schnittstelle (31) am oberen Gehäuse (30) derart gestaltet ist, dass sie durch die besagte Öffnung (11) des unteren Gehäuses (10) gleitet,
*und dass* die besagte externe Schnittstelle für den Anschluss an einen Verteilerrahmen (14) in dem besagten unteren Gehäuse ausgelegt ist.

3. Telekommunikationsschrank-Anordnung nach Anspruch **2,** ***dadurch gekennzeichnet, dass*** das besagte obere Gehäuse versiegelt ist.

4. Telekommunikationsschrank-Anordnung nach Anspruch **1,**
***dadurch gekennzeichnet, dass*** das besagte untere Gehäuse (10) eine Seite mit einer Zugangstür (12) mit einem ersten Schloss (13) aufweist,
*und dass* das besagte obere Gehäuse (30) eine Seite mit einer Zugangstür (32) mit einem zweiten Schloss (33) aufweist.

5. Telekommunikationsschrank-Anordnung nach Anspruch **4,** ***dadurch gekennzeichnet, dass*** die besagte eine Seite eine Vorderseite ist.

6. Telekommunikationsschrank-Anordnung nach Anspruch **1,**
***dadurch gekennzeichnet, dass*** die besagte Telekommunikationsschrank-Anordnung ein für die Aufstellung im Außenbereich bestimmter Verteilerschrank ist.

7. Unteres Telekommunikationsgehäuse (10) zum Unterbringen von passiven Vorrichtungen wie beispielsweise Hauptverteilerrahmen und -blöcke,
***dadurch gekennzeichnet, dass*** das besagte untere Gehäuse (10) eine mit einer Öffnung (11) versehene Oberseite aufweist, wobei die besagte Öffnung mit einem abnehmbaren, wasserdichten Oberteil (40) geschlossen werden und eine externe Schnittstelle (31) eines über dem besagten unteren Gehäuse angebrachten oberen Gehäuses (30), in welchem aktive Vorrichtungen wie beispielsweise Zugangsvorrichtungen und zusätzliche Verteilerrahmen und -blöcke für Kunden-Routing untergebracht sind, aufnehmen kann,
*und dass* die besagte externe Schnittstelle für den Anschluss an einen Verteilerrahmen (14) in dem besagten unteren Gehäuse ausgelegt ist.

8. Unteres Telekommunikationsgehäuse (10) nach Anspruch **7,** ***dadurch gekennzeichnet, dass*** das besagte untere Gehäuse (10) eine mit einer Zugangstür (12) mit einem ersten Schloss (13) versehene Seite aufweist.

9. Unteres Telekommunikationsgehäuse (10) nach Anspruch **8,** ***dadurch gekennzeichnet, dass*** die besagte eine Seite eine Vorderseite ist.

10. Unteres Telekommunikationsgehäuse (10) nach Anspruch **7,** ***dadurch gekennzeichnet, dass*** das besagte untere Gehäuse (10) ein für die Aufstellung im Außenbereich bestimmter Verteilerschrank ist.

## Revendications

1. Ensemble de boîtier de télécommunication comprenant une enceinte inférieure (10) hébergeant un équipement passif tel que des répartiteurs et des blocs de distribution principaux et une enceinte supérieure (30) hébergeant un équipement actif tel qu'un équipement d'accès ainsi que des répartiteurs et des blocs de distribution supplémentaires pour le routage client,
***caractérisé en ce que*** ladite enceinte supérieure (30) possède une partie inférieure dotée d'une interface externe (31),
***en ce que*** ladite enceinte inférieure (10) possède une partie supérieure dotée d'une ouverture (11),
*et **en ce que*** ladite enceinte supérieure est adaptée pour être placée sur le dessus de ladite enceinte inférieure où ladite interface externe est insérée dans ladite ouverture.

2. Ensemble de boîtier de télécommunication selon la revendication **1,**
***caractérisé en ce que*** ladite interface externe (31) de l'enceinte supérieure (30) est adaptée pour se glisser dans ladite ouverture (11) de l'enceinte inférieure (10),
*et **en ce que** ladite* interface externe est adaptée pour être connectée à un répartiteur (14) dans ladite enceinte inférieure.

3. Ensemble de boîtier de télécommunication selon la revendication **2,** ***caractérisé en ce que*** ladite enceinte supérieure est scellée.

4. Ensemble de boîtier de télécommunication selon la revendication **1,**
***caractérisé en ce que*** ladite enceinte inférieure (10) possède une face dotée d'une porte d'accès (12) équipée d'un premier verrou (13),
*et **en ce que*** ladite enceinte supérieure (30) possède une face dotée d'une porte d'accès (32) équipée d'un deuxième verrou (33).

5. Ensemble de boîtier de télécommunication selon la revendication **4,** ***caractérisé en ce que*** ladite une face est une face avant.

6. Ensemble de boîtier de télécommunication selon la revendication **1,**
***caractérisé en ce que*** ledit ensemble de boîtier de télécommunication est un répartiteur public adapté pour être placé en extérieur.

7. Enceinte inférieure de télécommunication (10) pour héberger un équipement passif tel que des répartiteurs et blocs de distribution principaux,
***caractérisée en ce que*** ladite enceinte inférieure (10) possède une face supérieure dotée d'une ouverture (11) adaptée pour être fermée à l'aide d'une pièce supérieure amovible résistante à l'eau (40) et pour recevoir une interface externe (31) d'une enceinte supérieure (30) hébergeant un équipement actif tel qu'un équipement d'accès ainsi que des répartiteurs et blocs de distribution supplémentaires pour le routage client placés sur le dessus de ladite enceinte inférieure,
*et **en ce que*** ladite interface externe est adaptée pour être connectée à un répartiteur (14) dans ladite enceinte inférieure.

8. Enceinte inférieure de télécommunication (10) selon la revendication **7,** ***caractérisée en ce que*** ladite enceinte inférieure (10) possède une face dotée d'une porte d'accès (12) équipée d'un premier verrou (13).

9. Enceinte inférieure de télécommunication (10) selon la revendication **8,** ***caractérisée en ce que*** ladite une face est une face avant.

10. Enceinte inférieure de télécommunication (10) selon la revendication **7,** ***caractérisée en ce que*** ladite enceinte inférieure (10) est un répartiteur public adapté pour être placé en extérieur.
